# EUROPÄISCHE PATENTSCHRIFT

(11) **EP 0 666 479 B1**
(45) Veröffentlichungstag und Bekanntmachung des Hinweises auf die Patenterteilung: **14.05.2003**
(21) Anmeldenummer: 95101323.4
(22) Anmeldetag: 01.02.1995
(51) Int. Cl.: G01R 21/00, G01R 21/133

(54) **Messeinrichtung und Verfahren zur Messung der Wirkleistung**
Measuring device and active power measuring method
Dispositif de mesure et méthode pour mesurer la puissance active

(30) Priorität: 05.02.1994 DE 4403642
(43) Veröffentlichungstag der Anmeldung: 09.08.1995
(73) Patentinhaber: AEG SVS Power Supply Systems GmbH, 59581 Warstein-Belecke (DE)
(72) Erfinder: Hesse, Christian, Dipl.-Ing., D-59581 Warstein (DE); Jury, Reinhard, Dipl.-Ing., D-59929 Brilon (DE); Schaffarra, Christian, Dipl.-Ing., D-59602 Rüthen (DE)
(74) Vertreter: Fritz, Edmund Lothar, Dipl.-Chem.

(56) Entgegenhaltungen:
- EP-A- 0 332 881
- DE-A- 3 005 672
- DE-C- 3 919 114
- GB-A- 2 066 969

## Beschreibung

Die Erfindung betrifft zum einen ein Verfahren zur Messung der Wirkleistung, die von einer Last in einem Stromnetz mit mindestens einer Phase aufgenommen wird, wobei in mindestens einer Phase zunächst während mindestens einer Netzperiode ein dem gleichgerichteten Laststrom proportionaler Wert gebildet wird und eine gespeicherte Tabelle mit normierten elektrischen Größen angewendet wird, und zum andern eine Meßeinrichtung zum Messen der Wirkleistung, die von einer Last in einem Stromnetz mit mindestens einer Phase aufgenommen wird, mit einem Einweggleichrichter für einen dem Laststrom proportionalen Strom in mindestens einer Phase, mit einem Mikrocontroller und mit einem Speicher, in dem eine Tabelle mit normierten elektrischen Größen abrufbar abgelegt ist.

Eine derartiges Verfahren und eine solche Meßeinrichtung sind aus der DE-B-39 19 114 bekannt.

Es ist grundsätzlich möglich, für die Wirkleistungsmessung in einem einoder mehrphasigen Wechselstromnetz in jeder Phase Strom und Spannung an der Last zu messen, die zeitlich zusammengehörigen Werte miteinander zu multiplizieren und anschließend über mindestens eine Periodendauer zu mitteln.

Dazu ist allerdings ein recht hoher Aufwand erforderlich, außerdem sind bei analoger Messung teure Präzisionsbauteile notwendig.

Der Erfindung liegt die Aufgabe zugrunde, zum einen ein Verfahren der eingangs genannten Art zum Messen der von einer Last aufgenommenen Wirkleistung bereitzustellen, bei dem möglichst wenige Meßgrößen zur Ermittlung der Wirkleistung erforderlich sind, und zum andern eine möglichst einfache Meßeinrichtung zur Durchführung des Verfahrens zu schaffen.

Diese Aufgabe wird erfindungsgemäß dadurch gelöst, daß
- daß der dem Laststrom proportionale Wert zu verschiedenen Zeitpunkten jeweils digitalisiert wird, daß anschließend aus der Tabelle, in der normierte, zu verschiedenen Zeitpunkten einer Netzperiode gehörende Spannungswerte gespeichert sind, die zu den Zeitpunkten der erwähnten Digitalisierung gehörigen, vom Verlauf der Netzspannung abhängigen, normierten Spannungswerte gelesen und paarweise mit den digitalisierten Werten multipliziert werden und daß danach die durch die Multiplikation entstandenen Werte addiert und schließlich gemittelt werden, und dadurch
- daß die Meßeinrichtung eine digitale Auswerteeinheit, einen dem Eingweggleichrichter nachgeschalteten, einzelne Werte des gleichgerichteten Laststroms digitalisierenden A/D-Umsetzer und einen Speicher enthält, in dem für mindestens eine Phase eine Tabelle mit von dem Mikrocontroller abrufbaren normierten Spannungswerten, die zu verschiedenen Zeitpunkten einer Netzperiode gehören, gespeichert sind, und daß die Meßeinrichtung zusätzlich eine Netzsynchronisationseinrichtung aufweist, die dafür sorgt, daß zu jedem digitalisierten Wert für den Laststrom aus der Tabelle ein zugehöriger normierter Spannungswert, der dem gerade anliegenden Betrag der Netzspannung zuzuordnen ist, von der digitalen Auswerteeinheit abrufbar ist.

Vorteilhaft bei dem Verfahren ist die Tatsache, daß zur Messung der Wirkleistung als einzige Meßgröße der Laststrom erforderlich ist. Die zur Bestimmung der Wirkleistung zusätzlich nötigen Spannungswerte sind in einer Tabelle gespeichert.

Günstig ist eine Digitalisierung des gleichgerichteten Laststroms zu äquidistanten Zeiten, d. h. zu Zeitpunkten mit gleichem Abstand untereinander. In diesem Falle läß sich der tatsächliche Verlauf des Stromes möglichst genau erfassen.
Aus dem gleichen Grunde können die in der Tabelle gespeicherten Spannungswerte zu äquidistanten Zeiten aufgenomme Werte sein.

Wenn Schwankungen der Netzspannung bei der Wirkleistungsmessung berücksichtigt werden sollen, ist es vorteilhaft, den Scheitelwert der Spannung in jeder Netzperiode zu messen und in die Berechnung einfließen zu lassen. Dazu müssen die in der Tabelle gespeicherten Spannungswerte unter Berücksichtigung des gerade gemessenen Scheitelwertes entsprechend gewichtet werden.

Die erfindungsgemäße Meßeinrichtung kann sowohl am Einphasennetz als auch am Dreiphasennetz betrieben werden.

Im folgenden wird ein Ausführungsbeispiel der Erfindung anhand dreier Zeichnungen, aus denen sich weitere Einzelheiten und Vorteile ergeben, näher beschrieben.

Es zeigen:
- Fig. 1: ein mögliches Blockschaltbild der Meßeinrichtung,
- Fig. 2: den Verlauf von Spannung, Strom und Leistung während einer Netzperiode bei einem einphasigen Netz und
- Fig. 3: die digitalisierten Werte von Spannung und Strom und die Werte des Produktes aus den zugehörigen Spannungs- und Stromwerten.

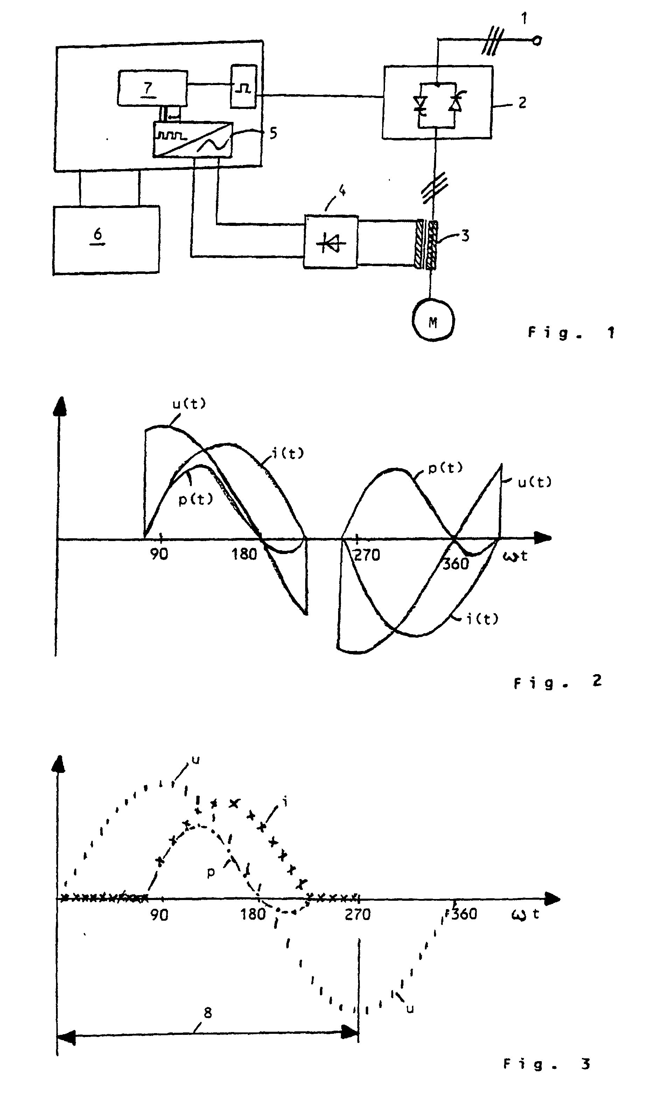

In Fig. 1 ist der prinzipielle Aufbau einer Meßschaltung zur Wirkleistungsmessung zu sehen. An einem Drehstromnetz (1) wird ein Asynchronmotor (M) betrieben, der über einen vorgeschalteten Thyrsitorsteller (2) gesteuert wird. Zwischen dem Thyristorsteller (2) und dem Asynchronmotor (M) befindet sich in jeder Phase ein Stromwandler (3), der von dem Laststrom durchflossen wird und an den ausgangsseitig (in jeder Phase) jeweils ein Einweggleichrichter (4) angeschlossen ist.

Der Ausgang des Einweggleichrichters (4) ist verbunden mit einem Analog-Digital-Umsetzer (5), der zu äquidistanten Zeiten den gleichgerichteten Strom in digitale Signale wandelt.

In einem Speicher (6) - üblicherweise ein ROM - ist eine Tabelle abrufbar, in der digitalisierte, normierte, zu äquidistanten Zeiten erfaßte Spannungswerte einer Netzperiode gespeichert sind. Der Inhalt der Tabelle ist von einem Mikrocontroller (7) abrufbar. In dem Mikrocontroller (7) wird aus den Werten von Strom und Spannung die mittlere Wirkleistung einer Periode bestimmt.

Der Mikrocontroller (7) gibt Stromimpulse zur Ansteuerung der Thyristoren des Thyristorstellers (2) ab.

Fig. 2 veranschaulicht, wie sich die Augenblicksleistung p(t) durch Multiplikation der Augenblickswerte von Strom (i(t)) und Spannung (u(t)) bestimmen läßt.

Es ist der Strom (i(t)) und die (Netz-)Spannung (u(t)) dargestellt, wie sie in einer einzigen Netzperiode auftreten, wobei ein Steuerwinkel (α) von 75° bei der Zündung der Thyristoren im Thyristorsteller (2) und eine Phasenverschiebung zwischen Spannung (u(t)) und Strom (i(t)) von 45° berücksichtigt ist.

Die Fig. 3 dient dem Verständnis eines vereinfachten Verfahrens zur Messung der von einem Verbraucher aufgenommenen Wirkleistung, wobei die Schaltung nach Fig. 1 zugrunde gelegt ist. Normierte, digitalisierte Spannungswerte (u) einer einzigen Netzperiode sind in der Tabelle (im Speicher (6)) abgelegt. Der gleichgerichtete Strom auf der Sekundärseite des Stromwandlers (3) wird zunächst digitalisiert. Daraus entstehen Stromwerte (i). Mit Hilfe einer (nicht illustrierten) Netzsynchronisationseinrichtung werden aus der Tabelle nacheineinder diejenigen Spannungswerte (u) abgerufen, die zu der während der Digitalisierung der Stromwerte (i) vorhandenen Netzspannung gehören. Anschließend werden die digitalisierten Stromwerte (i) mit den zugehörigen Spannungswerten (u) der Tabelle einzeln miteinander multipliziert. Dies ergibt Augenblickswerte für die Leistung (p). Diese Augenblickswerte werden dann aufaddiert.
Das Ergebnis wird gemittelt durch Division durch die Anzahl der digitalisierten Stromwerte (i) in einem Meßzyklus (8) der Netzspannung.

Der so ermittelte Wert ist proportional der Wirkleistung in dieser Periode.

## Patentansprüche

1. Verfahren zur Messung der Wirkleistung, die von einer Last in einem Stromnetz mit mindestens einer Phase aufgenommen wird, wobei in mindestens einer Phase zunächst während mindestens einer Netzperiode ein dem gleichgerichteten Laststrom proportionaler Wert gebildet wird und eine gespeicherte Tabelle mit normierten elektrischen Größen angewendet wird,
**dadurch gekennzeichnet,**
**daß** der dem Laststrom proportionale Wert zu verschiedenen Zeitpunkten jeweils digitalisiert wird, daß anschließend aus der Tabelle, in der normierte, zu verschiedenen Zeitpunkten einer Netzperiode gehörende Spannungswerte gespeichert sind, die zu den Zeitpunkten der erwähnten Digitalisierung gehörigen, vom Verlauf der Netzspannung abhängigen, normierten Spannungswerte gelesen und paarweise mit den digitalisierten Werten multipliziert werden und daß danach die durch die Multiplikation entstandenen Werte addiert und schließlich gemittelt werden.

2. Verfahren nach Anspruch 1,
**dadurch gekennzeichnet,**
**daß** aus den durch Multiplikation entstandenen Werten der arithmetische Mittelwert gebildet wird.

3. Verfahren nach Anspruch 1 oder 2,
**dadurch gekennzeichnet,**
**daß** die dem gleichgerichteten Laststrom proportionalen Werte zu äquidistanten Zeiten digitalisiert werden.

4. Verfahren nach einem der vorangehenden Ansprüche,
**dadurch gekennzeichnet,**
**daß** die in der Tabelle gespeicherten Spannungswerte zu äquidistanten Zeiten aufgenommene, normierte Spannungswerte sind.

5. Verfahren nach einem der vorangehenden Ansprüche,
**dadurch gekennzeichnet,**
**daß** zusätzlich der Scheitelwert der Spannung innerhalb der Netzperioden der oder jeder Phase gemessen wird, daß anschließend ein Proportionalitätsfaktor bestimmt wird, der das Verhältnis des Scheitelwerts der tatsächlichen Spannung zum Scheitelwert nach den in der Tabelle gespeicherten Spannungswerten berücksichtigt, und daß mit Hilfe dieses Proportionalitätsfaktors die in der Tabelle gespeicherten Spannungswerte bei der Berechnung der Wirkleistung an die tatsächlichen Spannungswerte angepaßt werden.

6. Meßeinrichtung zum Messen der Wirkleistung, die von einer Last In einem Stromnetz mit mindestens einer Phase aufgenommen wird, mit einem Einweggleichrichter (4) für einen dem Laststrom proportionalen Strom in mindestens einer Phase, mit einem Mikrocontroller (7) und mit einem Speicher (6), in dem eine Tabelle mit normierten elektrischen Größen abrufbar abgelegt ist,
**dadurch gekennzeichnet,**
**daß** die Meßeinrichtung eine digitale Auswerteeinheit, einen dem Eingweggleichrichter (4) nachgeschalteten, einzelne Werte des gleichgerichteten Laststroms digitalisierenden A/D-Umsetzer (5) und einen Speicher (6) enthält, in dem für mindestens eine Phase eine Tabelle mit von dem Mikrocontroller (7) abrufbaren normierten Spannungswerten, die zu verschiedenen Zeitpunkten einer Netzperiode gehören, gespeichert sind, und daß die Meßeinrichtung zusätzlich eine Netzsynchronisationseinrichtung aufweist, die dafür sorgt, daß zu jedem digitalisierten wert für den Laststrom aus der Tabelle ein zugehöriger normierter Spannungswert, der dem gerade anliegenden Betrag der Netzspannung zuzuordnen ist, von der digitalen Auswerteeinheit abrufbar ist.

7. Meßeinrichtung nach Anspruch 6,
**dadurch gekennzeichnet,**
**daß** das Stromnetz ein Einphasennetz ist.

8. Meßeinrichtung nach Anspruch 6,
**dadurch gekennzeichnet,**
**daß** das Stromnetz ein Dreiphasennetz ist.

## Claims

1. Process for active power measurement, that is made by a load in an electric network with at least one phase, first forming one proportional value to the rectified load current in at least one phase during at least one network cycle and a stored table with normalised electric magnitudes being applied, **characterized in that** the proportional value to the load current is digitised at different times, that afterwards normalised voltage values are stored from the table belonging to different times of a network cycle, that are read at the mentioned digitalisation moments, belonging to the normalised voltage values in dependence of the network voltage development, and that then the values obtained by multiplication are added and finally the mean values are obtained.

2. Process according to claim 1, **characterized in that** from the values originated by multiplication the arithmetic mean value is formed.

3. Process according to claim 1 or 2, **characterized in that** the rectified load current proportional values are digitised at equidistant times.

4. Process according to one of the aforementioned claims, **characterized in that** the voltage values stored in the table are normalised voltage values at equidistant times.

5. Process according to one of the aforementioned claims, **characterized in that** additionally the voltage peak value is measured during one or during every phase, that a proportionality factor is determined afterwards, considering the peak value relation of the real voltage to peak value according to the voltage values stored in the table, and that with the help of this proportionality factor the voltage values stored in the table during calculation of the active power are adapted to the real voltage values.

6. Measuring device for active power measuring, made by a load within an electric network with at least one phase, with a single-wave rectifier (4) for a proportional current to load current in at least one phase, with a micro-controller (7) and with one memory (6), in which a table with normalised electric magnitudes is deposited, **characterized in that** the measuring device includes a digital evaluation unit, one analogue-to-digital coder (5) digitalizing single values of rectified load current post-connected to the single-wave rectifier (4), and one memory (6), in which normalised voltage values, which can be called up by the micro-controller (7) are stored on the table for at least one phase, they belong to different moments of a network cycle, and the measuring device additionally shows a network synchronization device, that allows calling up a corresponding normalised voltage value from the table by means of the digitised value for the load current which has to be assigned to the amount of network voltage adjusted at that moment.

7. Measuring device according to claim 6, **characterized in that** the electric network is a single-phase network.

8. Measuring device according to claim 6, **characterized by** the fact, that the electric network is a three-phase network.

## Revendications

1. Procédé pour le mesurage de la puissance active lequel est réalisé moyennant une charge dans un réseau électrique avec au moins une phase, formant dans un premier temps une valeur proportionnelle au courant de charge rectifié, pendant au moins une phase pendant au moins une période du réseau, et un tableau dans lequel sont enregistrées des grandeurs électriques normalisées, **caractérisé par le fait que** la valeur proportionnelle au courant de charge est toujours numérisée lors de différents moments, que successivement à partir du tableau sont mémorisées des valeurs de tension normalisées appartenant à une période du réseau lors de différents moments, qui sont lues lors des moments de numérisation mentionnées, dépendantes du déroulement de la tension du réseau, lesquelles sont multipliées par paires avec les valeurs numérisées et que successivement les valeurs obtenues par la multiplication sont additionnées, la valeur moyenne étant finalement obtenue.

2. Procédé selon la revendication 1, **caractérisé par le fait que** la valeur moyenne arithmétique est calculée à partir des valeurs obtenues par la multiplication.

3. Procédé selon la revendication 1 ou 2, **caractérisé par le fait que** les valeurs proportionnelles au courant de charge rectifié sont numérisées à des temps équidistants.

4. Procédé selon une des revendications précédentes, **caractérisé par le fait que** les valeurs de tension mémorisées dans le tableau sont des valeurs de tension normalisées et enregistrées à des temps équidistants.

5. Procédé selon une des revendications précédentes, **caractérisé par le fait, que** de plus la valeur maximale de la tension est mesurée lors d'une ou de chaque phase du réseau, qu'un facteur de proportionnalité est successivement déterminé lequel calcule le rapport entre la valeur maximale de la tension effective et la valeur maximale selon les valeurs de tension mémorisées dans le tableau, et qu'avec l'aide de ce facteur de proportionnalité, les valeurs de tension mémorisées dans le tableau pendant le calcul de la puissance active sont adaptées aux valeurs de tension effectives.

6. Dispositif de mesurage pour le mesurage de la puissance active lequel est réalisé moyennant une charge dans un réseau électrique avec au moins une phase, avec un redresseur à voie unique (4) pour un courant proportionnel au courant de charge dans au moins une phase, avec un micro-contrôleur (7) et avec une mémoire (6), dans laquelle est enregistré un tableau avec des magnitudes électriques normalisées qui peuvent être consultées, **caractérisé par le fait que** le dispositif de mesurage contient une unité d'évaluation, un convertisseur de courant alternatif et de courant continu (5) numérisant des valeurs individuelles du courant de charge rectifié, connecté postérieurement à un redresseur à voie unique (4), et à une mémoire (6), dans laquelle des valeurs de tension normalisées, qui peuvent être consultées moyennant le micro-contrôleur (7), sont enregistrées dans un tableau pour au moins une phase, lesquelles font parties de différents moments de période du réseau et que le dispositif de mesurage présente, en plus, un dispositif de synchronisation du réseau, qui permet de consulter, à partir du tableau, une valeur de tension normalisée correspondante moyennant l'unité d'évaluation numérique pour chaque valeur numérisée pour le courant de charge, qui doit être associée au total de la tension du réseau ajusté à ce moment-là.

7. Dispositif de mesurage selon la revendication 6, **caractérisé par le fait que** le réseau électrique est un réseau monophasé.

8. Dispositif de mesurage selon la revendication 6, **caractérisé par le fait que** le réseau électrique est un réseau triphasé.
